# EUROPEAN PATENT APPLICATION

(11) **EP 4 145 148 A1**
(43) Date of publication of application: **08.03.2023**
(21) Application number: 22189175.7
(22) Date of filing: 08.08.2022
(51) Int. Cl.: G01R 31/11

(54) **SYSTEM AND METHOD FOR IN-CABINET HEALTH MONITORING**

(30) Priority: 03.09.2021 US 202117466178
(71) Applicant: Rockwell Automation Technologies, Inc., Mayfield Heights, OH 44124 (US)
(72) Inventor: Zhang, Yanbin, Shanghai, 200431 (CN); Scudder, Austen Kolar, Milwuakee, 53207 (US); Tang, Benfeng, Shanghai, 200233 (CN)
(74) Representative: Grünecker Patent- und Rechtsanwälte PartG mbB

(57) **Abstract**

A system comprises a set of power conversion components powered by a power line system, and a time domain reflectometry apparatus coupled to the power line system. The time domain reflectometry apparatus is configured to acquire a reflection signal that results from reflection of an incident signal injected on the power line system, compute a difference signal based on the reflection signal and a baseline signal, and detect a fault in the set of power conversion components based on the difference signal and a fault pattern.

## Description

### BACKGROUND INFORMATION

The subject matter disclosed herein relates to power converters and to apparatus and techniques to monitor the health of power conversion system components.

### BRIEF DESCRIPTION

In one aspect, a system comprises a set of power conversion components powered by a power line system, and a time domain reflectometry apparatus coupled to the power line system. The time domain reflectometry apparatus is configured to acquire a reflection signal that results from reflection of an incident signal injected on the power line system, compute a difference signal based on the reflection signal and a baseline signal, and detect a fault in the set of power conversion components based on the difference signal and a fault pattern.

In another aspect, a method comprises acquiring a reflection signal that results from reflection of an incident signal injected on a power line system that powers a set of power conversion components, computing a difference signal based on the reflection signal and a baseline signal, and detecting a fault in the set of power conversion components based on the difference signal and a fault pattern.

In a further aspect, a non-transitory computer-readable medium has computer-executable instructions which, when executed by a processor, cause the processor to acquire a reflection signal that results from reflection of an incident signal injected on a power line system that powers a set of power conversion components, compute a difference signal based on the reflection signal and a baseline signal, and detect a fault in the set of power conversion components based on the difference signal and a fault pattern.

### BRIEF DESCRIPTION OF THE DRAWINGS

FIG. 1 is a schematic diagram of a power conversion system with an SSTRD device and a switch circuit.
FIG. 2 is a schematic diagram of a power conversion system with a three channel SSTRD device.
FIG. 3 is a schematic diagram of a power conversion system including a circuit breaker with an integrated SSTRD device.
FIG. 4 is a schematic diagram of the SSTRD device during testing of a power phase line.
FIG. 5 is a graph of baseline and fault SSTDR data.
FIG. 6 is a graph of difference data showing a fault pattern.
FIG. 7 is a view of a graphical user interface.
FIG. 8 is a flow diagram of a method

### DETAILED DESCRIPTION

Referring now to the figures, several embodiments or implementations are hereinafter described in conjunction with the drawings, wherein like reference numerals are used to refer to like elements throughout, and wherein the various features are not necessarily drawn to scale.

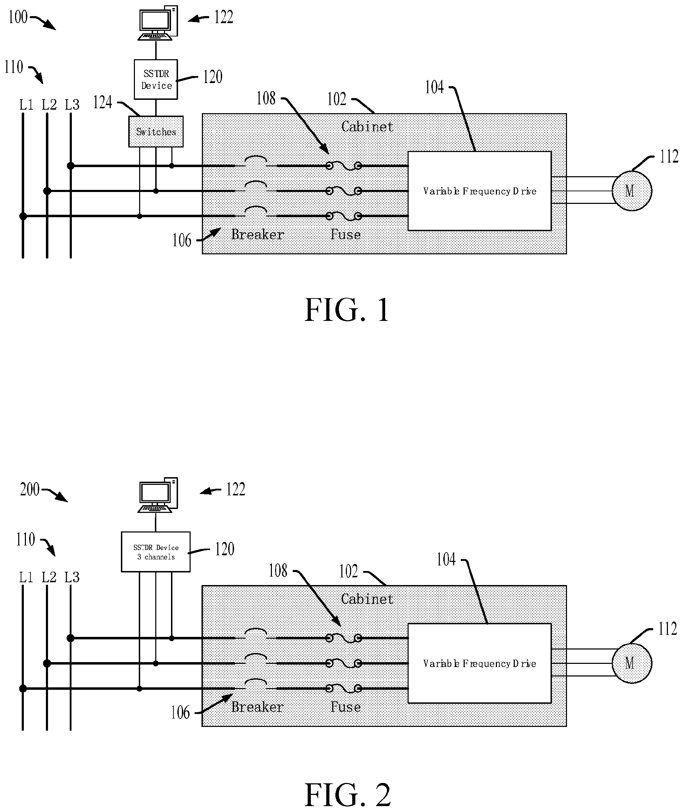

FIG. 1 shows a power conversion system 100 with an SSTRD device and a switch circuit. The example system is a power conversion system or power converter having a cabinet 102, such as a motor control center (MCC), with an interior that houses a set of power conversion components 104, 106, and 108, which are powered by a power line system 110. In the illustrated example, the power line system 110 is a three-phase system having multiple power lines LI, L2, and L3. In other implementations, a single phase power line system can be used (e.g., having two lines), or more than three phases can be used. The system 100 converts input power from the power line system 110 to deliver output power to drive a multiphase load, such as a three phase motor 112. In the illustrated implementation, the set of power conversion components includes a three-phase motor drive 104, a circuit breaker 106, and fuses 108. In one example, the motor drive 112 is a variable frequency drive (VFD).

The motor drive 104 is powered by the power line system 110, and is coupled to the power lines LI, L2, and L3 through a three-phase circuit breaker 106, and three in-line fuses 108. The motor control center 102 in one example includes multiple enclosed sections having a common power bus and with individual sections having a combination starter that includes a motor starter, fuses, and/or circuit breaker, and power disconnect (not shown). In addition to one or more motor drives 104, various implementations of the motor control center 102 can also include push buttons, indicator lights, programmable logic controllers, and metering equipment (not shown), and the MCC 102 may be combined with an electrical service entrance for a facility. In one example, individual motor control units or sections include a circuit breaker 106, fuses 108, and a VFD motor drive 104 as shown in FIG. 1. The health of the power line in the system 100 is important for commercial and/or industrial operations, wherein faults (e.g., breaker trips, blown fuses, loosening of wire connections, cable degradation or overheating, motor starter performance degradation, motor control contactor and control operation, load switch operation, etc.) can impact the commercial or industrial operation.

The described examples provide health monitoring apparatus, including a time domain reflectometry apparatus 120 coupled to the power line system 110. The time domain reflectometry apparatus 120 in one example is a spread spectrum time domain reflectometry (SSTDR) apparatus or device. The apparatus 120, moreover, advantageously operates while the power conversion components 104, 106, and 108 are powered and operating to drive the motor 112, referred to as "live wire" health monitoring, even for constrained installations (e.g., power line cable lengths of less than about 1 m, high voltage, high current, and in-cabinet features). In one implementation, the time domain reflectometry apparatus 120 is operatively coupled to a computer 122, for example, by appropriate communications network interconnections and cabling of any suitable type and protocol. In one example, the apparatus 120 and/or the computer 122 include one or more internal processors and associated electronic memory or other non-transitory computer-readable that store computer-executable instructions which, when executed by the processor or processors, implement a health monitoring program as described further hereinafter.

The time domain reflectometry apparatus 120 in one example is configured to generate and provide an incident signal to one or more of the power lines of the power line system 110 during operation of the motor drive power conversion system 100, and acquire one or more respective reflection signals that result from reflection of the incident signal injected on the power line system 110. In addition, the time domain reflectometry apparatus 120 is configured to compute a difference signal based on the reflection signal and a baseline signal, and detect a fault in the set of power conversion components 104, 106, and/or 108 based on the difference signal and a fault pattern. In the illustrated example, the time domain reflectometry apparatus 120 is also configured to identify a suspected one of the set of power conversion components 104, 106, and/or 108 that is suspected of being the source, based on the detected fault. In certain examples, the time domain reflectometry apparatus 120 is configured to determine a type of the detected fault as being a persistent fault or an intermittent fault. In these or other examples, the time domain reflectometry apparatus 120 is configured to adapt or otherwise adjust the fault pattern based on the detected fault.

In the example of FIG. 1, the time domain reflectometry apparatus 120 has a single channel, and the system 100 also includes a switch circuit 124 coupled between the time domain reflectometry apparatus 120 and the power line system 110. The switch circuit 124 in one example is operated by the time domain reflectometry apparatus 120 to selectively coupled the single channel of the time domain reflectometry apparatus 120 to a selected one of the power lines LI, L2, L3 of the power line system 110 for testing the selected power line. This configuration allows the time domain reflectometry apparatus 120 to sequentially perform reflectometry testing and assess the health of the individual power lines LI, L2, and L3 of the system 100 in real time during operation of the system 100 to drive the motor 112.

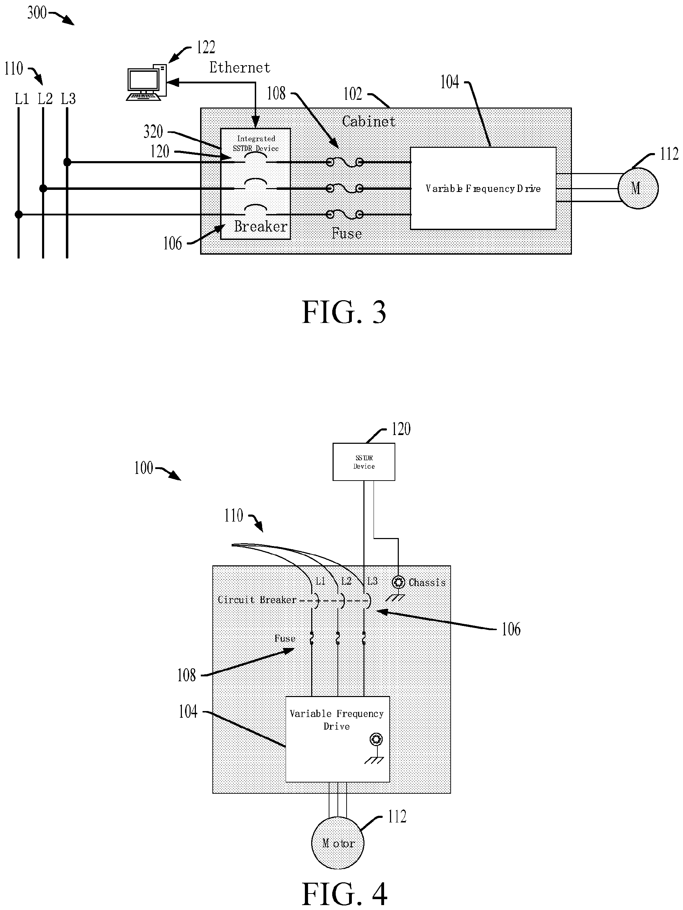

FIG. 2 shows another implementation of a power conversion system 200 having a three channel SSTRD device. In this example, the time domain reflectometry apparatus 120 has multiple channels individually coupled to a respective one of the power lines LI, L2, and L3 of the power line system 110. This example facilitates concurrent health monitoring of multiple power lines during operation of the system 200 to drive the motor 112. FIG. 3 shows another power conversion system 300 including a circuit breaker 320 with an integrated SSTRD device that includes the three-phase circuit breaker 106 and the three channel SSTDR apparatus 120 as described above in connection with FIG. 2. In this and other possible examples, the time domain reflectometry apparatus 120 is integrated into one of the power conversion components 104, 106, and/or 108.

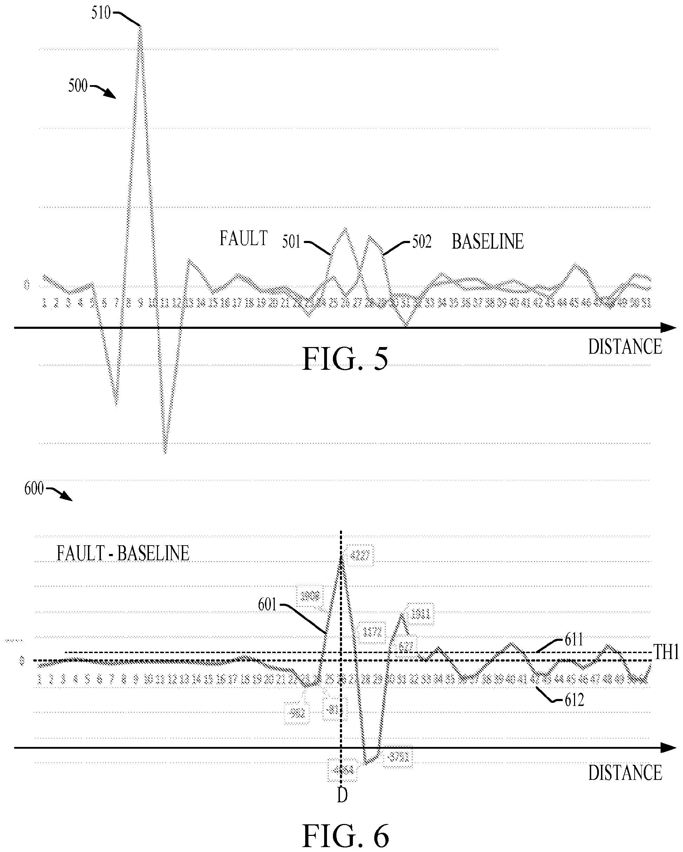

Referring also to FIGS. 4-6, FIG. 4 shows the time domain reflectometry apparatus 120 during testing of one example power phase line L3 in the system 100. FIG. 5 shows a graph 500 having a curve 501 that shows reflected fault SSTDR data and a curve 502 that shows baseline SSTDR data as a function of distance from the SSTDR apparatus 120 in the configuration of FIG. 4 during powered operation of the system 100. FIG. 6 shows a graph 600 including a curve 601 that shows SSTDR difference data showing a subtractive difference between the fault data and the baseline data in the system 100 for the acquired data illustrated in FIG. 5. In this example, a particular calibrated fault in one of the components 104, 106, or 108 of the system 100 generates reflected data corresponding to a distance D. At the distance D, the identifiable fault corresponds to difference data having a positive amplitude at or above a threshold 611 (TH1).

In one example for recognizing (detecting) and identifying an open circuit fault, the SSTDR apparatus 120 reports a fault with arrays of 92 raw data, and calculates or otherwise computes the difference (e.g., the difference curve 600) by subtracting the baseline or reference (e.g., curve 502) from the fault data (e.g., curve 501). The time domain reflectometry apparatus 120 determines the fault amplitude threshold (e.g., 3% of baseline launch spot 510 at sample 9 in FIG. 5). To bypass the launch spot 510, starting from sample 13 in the graph 500, the time domain reflectometry apparatus 120 looks for the peak which is greater than the fault threshold 611 (TH1). In one implementation for this example open circuit fault, the time domain reflectometry apparatus 120 determines a peak as such if there is a negative value in three samples to the left side and the right side of the peak. The time domain reflectometry apparatus 120 in one implementation stops further screening once it identifies the first such peak moving from left to right. In this example, only the one fault caused by a specific component which is close to the SSTDR time domain reflectometry apparatus 120 can be detected at a time, which is advantageous. In this example, for each waveform with a fault, only the first peak is evaluated, and all others thereafter are ripples and are not evaluated. Once the first peak is identified, the SSTDR time domain reflectometry apparatus 120 stops further evaluation and records the sample point of the peak for fault distance calculation, although it is less significant for constrained system. Based on the distance computation, the SSTDR time domain reflectometry apparatus 120 determines a fault name according to the peak amplitude to identify the likely source of the detected fault.

In one example fault distance calculation for an open circuit fault at 16.817 m, the SSTDR time domain reflectometry apparatus 120 identifies the point of peak as sample number 25, where the launch point is sample number 9 in FIGS. 5 and 6. The time domain reflectometry apparatus 120 in this example computes a distance resolution in meters as 2.99.79 × 10^{6 ∗} *VoP*/8^{∗}*f,* where *VoP* is the velocity of propagation of the line L3 and *f* is the SSTRD measurement frequency in Hz. In one example, the fault distance calculation includes the time domain reflectometry apparatus 120 computes the distance D = µ(*Sₙ* - Z), where *Sₙ* is the sample index number of the identified peak (e.g., 26) of the fault location, Z = 9 (e.g., the sample index number of the launch point 510, the speed of light is 3 × 10⁸ m/s, the velocity of propagation *VoP* is 0.68, the SSTRD measurement frequency /is 2.4 × 10⁷ Hz, and the distance resolution (e.g., distance per sample) *u* is 1.06.

In the illustrated example, the system component of interest exhibits a discernible fault that is recognized or otherwise identified by the time domain reflectometry apparatus 120 during powered operation of the power phase line L3. SSTDR implementations advantageously facilitate injection and reflection detection for powered phase lines, for example, that provide AC power to operate the system components 104, 106, and 108 at a suitable line frequency, such as approximately 50 Hz, 60 Hz, etc.

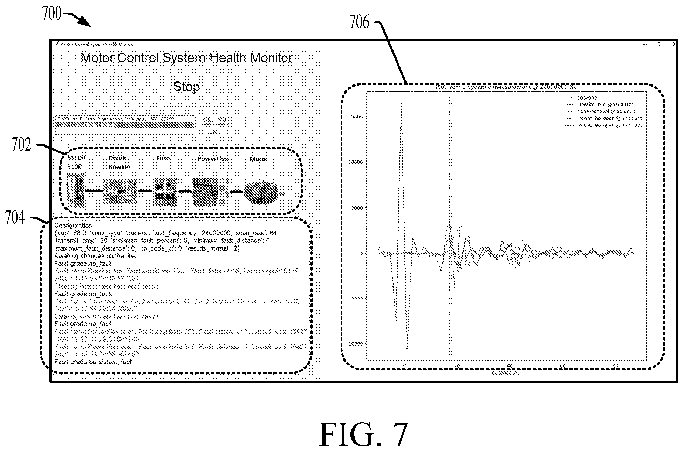

Referring also to FIG. 7, the time domain reflectometry apparatus 120 in one example is configured to render the detected fault on a user interface 700, for example, implemented in the time domain reflectometry apparatus 120 and/or the computer 122 in FIGS. 1-4 above. The example user interface 700 is a graphical user interface that displays or otherwise renders a graphical indication 702 of the interconnection of the powered devices and the time domain reflectometry apparatus 120 in the system 100, as well as a textual indication or rendering 704 of configuration parameters and time stamped descriptions of detected faults, in addition to a graphical representation or rendering 706 of SSTDR data associated with an incident signal and/or a reflected signal, alone or in addition to computed difference data and/or a calibrated fault pattern or profile associated with the system 100.

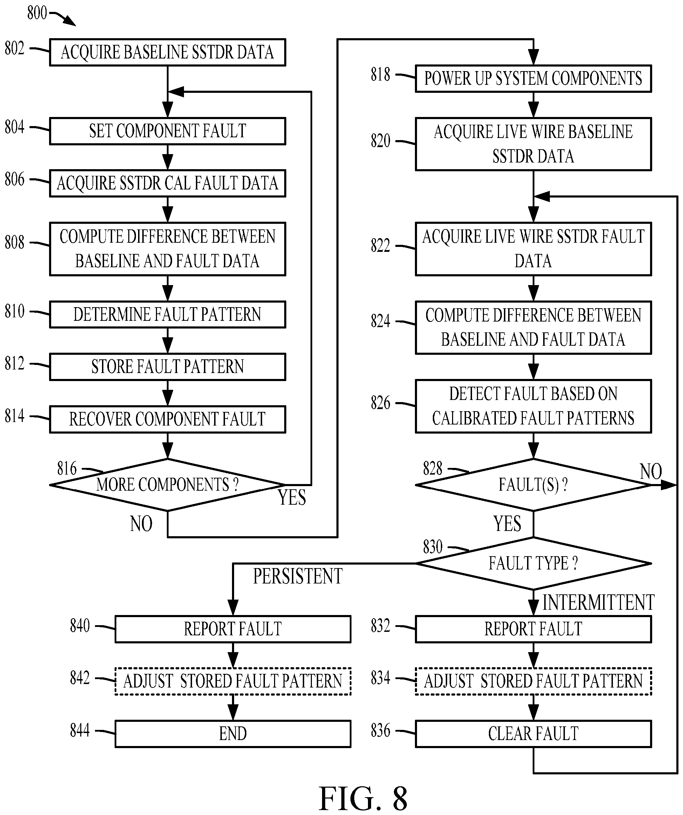

FIG. 8 shows a diagnostic method 800 implemented in one example by the time domain reflectometry apparatus 120 alone or in combination with the computer 122 illustrated and described above. The method 800 in this example begins with unpowered baseline characterization and fault calibration at 802-816, referred to as "dead wire calibration". At 802 in FIG. 8, the method 800 includes acquiring baseline SSTDR data in the system 100 while the system is unpowered (e.g., no supply voltages or currents are present in the power line system 110). At 804, a user or automated system sets a component fault, for example by turning off one, some or all phases of the circuit breaker 106 in FIG. 1 above. At 806, the time domain reflectometry apparatus 120 generates and injects one or more signals into the unpowered power line system 110 and acquires SSTDR data (e.g., referred to as calibration fault data) while the system 100 remains unpowered and the applied fault remains set (e.g., the circuit breaker 106 remains turned off).

At 808, the time domain reflectometry apparatus 120 calculates or otherwise computes the difference between the baseline and the calibration fault data, referred to as calibration difference data associated with a particular fault that is set. At 810, the time domain reflectometry apparatus 120 determines a fault pattern for the applied fault (e.g., breaker open), and the time domain reflectometry apparatus 120 stores the associated fault pattern in a memory of the computer 122 and/or a memory of the time domain reflectometry apparatus 120. At 814, the user or automated system recovers the previously set fault (e.g., closes the circuit breaker 106), and the time domain reflectometry apparatus 120 determines at 816 whether more components are to be calibrated or characterized (e.g., further faults are to be characterized in the system, whether of the previously calibrated component or of a further component. If so (YES at 816), the method 800 returns to 804-814 as described above to characterize further component faults in the system 100 while the system remains unpowered. The dead wire calibration process repeats for each testable component and/or fault associated there with.

Once the desired component faults have been characterized during the dead wire calibration processing at 802-814 (e.g., NO at 816), the method proceeds to baseline data acquisition while the system is powered, referred to as live wire baseline acquisition or capturing. At 818 in FIG. 8, the user or automated system powers up the system 100, for example, by turning main power on to all the system components, while not actively operating the power conversion components (e.g., while the motor drive 104 is not actively driving the motor load 112). At 820, the time domain reflectometry apparatus 120 acquires live wire baseline SSTDR data.

The method 800 then begins a continuously repeated live wire health monitoring loop, which continues in one example until a persistent fault is identified, leading to the system 100 shutting down pending maintenance or further analysis of the identified persistent fault. The example method 800 in this example also differentiates between persistent and intermittent faults in one or more of the calibrated system components, although not required for all possible implementations. The real time fault health monitoring, moreover, can be implemented alone or in combination with automated remedial actions responsive to certain identified faults, and numerous forms of reporting of the faults, for example, via the user interface (e.g., FIG. 7) and/or via network communications messaging to other devices in a networked factory automation system.

At 822, the time domain reflectometry apparatus 120 acquires live wire SSTDR fault data, and computes difference data at 824 between the live wire baseline data acquired eight 820, and the fault data acquired at 822. At 826, the time domain reflectometry apparatus 120 detects one or more faults. The live wire health monitoring in one implementation concurrently evaluates faults at 822 with respect to multiple calibrated faults, and certain implementations can concurrently identify multiple contemporaneous faults in the system 100 based on a single data acquisition at 822. At 824 and 826 in one example, the time domain reflectometry apparatus 120 computes the difference (e.g., graph 600), and detects the fault based on the calibrated fault patterns, and identifies at 828 which one caused the fault based on the previously stored fault patterns. In this regard, the time domain reflectometry apparatus 120 in one example uses stored profiles that represent what a certain type of fault might look like during operation of the system 100, whether it is an open circuit or a degraded wire having different profiles, etc., and the time domain reflectometry apparatus 120 is configured to interpret the acquired live wire data and indicate any suspected faults and render such to the user interface or to a networked computer element associated with the computer 122 or the time domain reflectometry apparatus 120. Continuing at 828, the time domain reflectometry apparatus 120 determines whether any fault or faults have been detected in the current loop iteration, and if not (NO at 828), the time domain reflectometry apparatus 120 performs another loop at 822-828 as previously described.

In response to detection of one or more faults (YES at 828), the time domain reflectometry apparatus 120 determines a type for each detected fault at 830. In this example, the time domain reflectometry apparatus 120 distinguishes between intermittent and persistent detected faults, for example, using a memory to indicate the presence or absence of each calibrated fault within a certain number of previous iterations of the loop 822-828. In the illustrated implementation, if the time domain reflectometry apparatus 120 determines that a particular detected fault is intermittent (INTERMITTENT at 830), the method 800 proceeds to 832 where the time domain reflectometry apparatus 120 reports the detected intermittent fault, for example, using the user interface features shown in FIG. 7 above alone or in addition to network messaging to notify a user or a networked computer within a factory automation system. In one example, the time domain reflectometry apparatus 120 adapts or otherwise adjusts one or more stored fault patterns based on the detected intermittent fault. The time domain reflectometry apparatus 120 in one example clears the detected fault at 836, and returns to begin another live wire health monitoring loop at 822-828 as previously described.

If the time domain reflectometry apparatus 120 determines that a detected fault is persistent (PERSISTENT at 830), the time domain reflectometry apparatus 120 reports the persistent fault at 840, for example, via a user interface or network messaging, and the time domain reflectometry apparatus 120 adapts or otherwise adjusts one or more stored fault patterns at 842 based on the detected persistent fault. In the illustrated implementation, following this reporting and selective adaptation regarding a detected persistent fault, the example method 800 ends at 844.

Various embodiments have been described with reference to the accompanying drawings. Modifications and changes may be made thereto, and additional embodiments may be implemented, without departing from the broader scope of the invention as set forth in the claims that follow. The specification and drawings are accordingly to be regarded in an illustrative rather than restrictive sense. The above examples are merely illustrative of several possible embodiments of various aspects of the present disclosure, wherein equivalent alterations and/or modifications will occur to others skilled in the art upon reading and understanding this specification and the annexed drawings. In addition, although a particular feature of the disclosure may have been disclosed with respect to only one of several implementations, such feature may be combined with one or more other features of the other implementations as may be desired and advantageous for any given or particular application. Also, to the extent that the terms "including", "includes", "having", "has", "with", or variants thereof are used in the detailed description and/or in the claims, such terms are intended to be inclusive in a manner similar to the term "comprising".

### The following is a list of further preferred embodiments of the invention:

Embodiments 1: A system, comprising:
   a set of power conversion components powered by a power line system; and
   a time domain reflectometry apparatus coupled to the power line system, the time domain reflectometry apparatus configured to:
   acquire a reflection signal that results from reflection of an incident signal injected on the power line system,
   compute a difference signal based on the reflection signal and a baseline signal, and
   detect a fault in the set of power conversion components based on the difference signal and a fault pattern.
Embodiments 2: The system of embodiment 1, wherein the time domain reflectometry apparatus is a spread spectrum time domain reflectometry apparatus.
Embodiments 3: The system of embodiment 2, wherein the time domain reflectometry apparatus is configured to identify a suspected one of the set of power conversion components based on the detected fault.
Embodiments 4: The system of embodiment 2, wherein:
   the power line system includes multiple power lines;
   the time domain reflectometry apparatus has a single channel; and
   the system further comprises a switch circuit configured to selectively coupled the single channel of the time domain reflectometry apparatus to a selected one of the power lines of the power line system.
Embodiments 5: The system of embodiment 2, wherein:
   the power line system includes multiple power lines; and
   the time domain reflectometry apparatus has multiple channels individually coupled to a respective one of the power lines of the power line system.
Embodiments 6: The system of embodiment 2, wherein the time domain reflectometry apparatus is integrated into one of the power conversion components.
Embodiments 7: The system of embodiment 1, wherein:
   the power line system includes multiple power lines;
   the time domain reflectometry apparatus has a single channel; and
   the system further comprises a switch circuit configured to selectively coupled the single channel of the time domain reflectometry apparatus to a selected one of the power lines of the power line system.
Embodiments 8: The system of embodiment 1, wherein:
   the power line system includes multiple power lines; and
   the time domain reflectometry apparatus has multiple channels individually coupled to a respective one of the power lines of the power line system.
Embodiments 9: The system of embodiment 1, wherein the time domain reflectometry apparatus is integrated into one of the power conversion components.
Embodiments 10: The system of embodiment 1, wherein the time domain reflectometry apparatus is configured to determine a type of the detected fault as being a persistent fault or an intermittent fault.
Embodiments 11: The system of embodiment 1, wherein the time domain reflectometry apparatus is configured to render the detected fault on a user interface.
Embodiments 12: The system of embodiment 1, wherein the time domain reflectometry apparatus is configured to adjust the fault pattern based on the detected fault.
Embodiments 13: A method, comprising:
   acquiring a reflection signal that results from reflection of an incident signal injected on a power line system that powers a set of power conversion components;
      computing a difference signal based on the reflection signal and a baseline signal; and
   detecting a fault in the set of power conversion components based on the difference signal and a fault pattern.
Embodiments 14: The method of embodiment 13, further comprising:
   identifying a suspected one of the set of power conversion components based on the detected fault.
Embodiments 15: The method of embodiment 13, further comprising:
   determining a type of the detected fault as being a persistent fault or an intermittent fault.
Embodiments 16: The method of embodiment 13, further comprising:
   rendering the detected fault on a user interface.
Embodiments 17: The method of embodiment 13, further comprising:
   adjusting the fault pattern based on the detected fault.
Embodiments 18: A non-transitory computer-readable medium having computer-executable instructions which, when executed by a processor, cause the processor to:
   acquire a reflection signal that results from reflection of an incident signal injected on a power line system that powers a set of power conversion components;
      compute a difference signal based on the reflection signal and a baseline signal; and
   detect a fault in the set of power conversion components based on the difference signal and a fault pattern.
Embodiments 19: The computer-readable medium of embodiment 18, comprising further computer-readable instructions which, when executed by the processor, cause the processor to:
   identify a suspected one of the set of power conversion components based on the detected fault.
Embodiments 20: The computer-readable medium of embodiment 18, comprising further computer-readable instructions which, when executed by the processor, cause the processor to:
   determine a type of the detected fault as being a persistent fault or an intermittent fault.

## Claims

1. A system, comprising:
a set of power conversion components powered by a power line system; and
a time domain reflectometry apparatus coupled to the power line system, the time domain reflectometry apparatus configured to:
acquire a reflection signal that results from reflection of an incident signal injected on the power line system,
compute a difference signal based on the reflection signal and a baseline signal, and
detect a fault in the set of power conversion components based on the difference signal and a fault pattern.

2. The system of claim 1, wherein the time domain reflectometry apparatus is a spread spectrum time domain reflectometry apparatus.

3. The system of claim 2, wherein the time domain reflectometry apparatus is configured to identify a suspected one of the set of power conversion components based on the detected fault.

4. The system of claim 2, wherein:
the power line system includes multiple power lines;
the time domain reflectometry apparatus has a single channel; and
the system further comprises a switch circuit configured to selectively coupled the single channel of the time domain reflectometry apparatus to a selected one of the power lines of the power line system.

5. The system of claim 2, wherein:
the power line system includes multiple power lines; and
the time domain reflectometry apparatus has multiple channels individually coupled to a respective one of the power lines of the power line system.

6. The system of claim 2, wherein the time domain reflectometry apparatus is integrated into one of the power conversion components.

7. The system of one of claims 1 to 6, wherein:
the power line system includes multiple power lines;
the time domain reflectometry apparatus has a single channel; and
the system further comprises a switch circuit configured to selectively coupled the single channel of the time domain reflectometry apparatus to a selected one of the power lines of the power line system.

8. The system of one of claims 1 to 7, wherein:
the power line system includes multiple power lines; and
the time domain reflectometry apparatus has multiple channels individually coupled to a respective one of the power lines of the power line system.

9. The system of one of claims 1 to 8, wherein the time domain reflectometry apparatus is integrated into one of the power conversion components.

10. The system of one of claims 1 to 9, wherein the time domain reflectometry apparatus is configured to determine a type of the detected fault as being a persistent fault or an intermittent fault.

11. The system of one of claims 1 to 10, wherein the time domain reflectometry apparatus is configured to render the detected fault on a user interface; or
wherein the time domain reflectometry apparatus is configured to adjust the fault pattern based on the detected fault.

12. A method, comprising:
acquiring a reflection signal that results from reflection of an incident signal injected on a power line system that powers a set of power conversion components;
computing a difference signal based on the reflection signal and a baseline signal; and
detecting a fault in the set of power conversion components based on the difference signal and a fault pattern.

13. The method of claim 12, further comprising:
identifying a suspected one of the set of power conversion components based on the detected fault; or
further comprising:
determining a type of the detected fault as being a persistent fault or an intermittent fault; or
further comprising:
rendering the detected fault on a user interface; or
further comprising:
adjusting the fault pattern based on the detected fault.

14. A non-transitory computer-readable medium having computer-executable instructions which, when executed by a processor, cause the processor to:
acquire a reflection signal that results from reflection of an incident signal injected on a power line system that powers a set of power conversion components;
compute a difference signal based on the reflection signal and a baseline signal; and
detect a fault in the set of power conversion components based on the difference signal and a fault pattern.

15. The computer-readable medium of claim 14, comprising further computer-readable instructions which, when executed by the processor, cause the processor to:
identify a suspected one of the set of power conversion components based on the detected fault; or
comprising further computer-readable instructions which, when executed by the processor, cause the processor to:
determine a type of the detected fault as being a persistent fault or an intermittent fault.
